(19) Europäisches Patentamt / European Patent Office / Office européen des brevets

(11) **EP 3 222 968 B1**

(12) **EUROPÄISCHE PATENTSCHRIFT**

(45) Veröffentlichungstag und Bekanntmachung des Hinweises auf die Patenterteilung:
**23.01.2019 Patentblatt 2019/04**

(51) Int Cl.:
*G01C 19/5776* *(2012.01)*    *H03M 3/02* *(2006.01)*

(21) Anmeldenummer: **17162268.1**

(22) Anmeldetag: **22.03.2017**

(54) **VERFAHREN ZUR AUTOMATISCHEN FREQUENZANPASSUNG VON FILTERN WÄHREND DES BETRIEBS IN GESCHLOSSENEN REGELSCHLEIFEN**

METHOD FOR AUTOMATIC FREQUENCY ADJUSTMENT OF FILTERS DURING OPERATION IN CLOSED CONTROL LOOPS

PROCÉDÉ D'ADAPTATION DE FRÉQUENCE AUTOMATIQUE DE FILTRES PENDANT LE FONCTIONNEMENT DANS UNE BOUCLE DE RÉGULATION FERMÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.03.2016   DE 102016204683**

(43) Veröffentlichungstag der Anmeldung:
**27.09.2017   Patentblatt 2017/39**

(73) Patentinhaber: **Albert-Ludwigs-Universität Freiburg**
**79098 Freiburg (DE)**

(72) Erfinder:
 • **MARX, Maximilian**
  **79104 Freiburg (DE)**
 • **DE DORIGO, Daniel**
  **79106 Freiburg (DE)**
 • **MANOLI, Yiannos**
  **79104 Freiburg (DE)**

(74) Vertreter: **Grünecker Patent- und Rechtsanwälte PartG mbB**
**Leopoldstraße 4**
**80802 München (DE)**

(56) Entgegenhaltungen:
 • **HUANZHANG HUANG; LEE, E.K.F.: "Frequency and Q tuning techniques for continuous-time bandpass sigma-delta modulator", CIRCUITS AND SYSTEMS, 2002. ISCAS 2002. IEEE INTERNATIONAL SYMPOSIUM ON, Bd. 5, 2002, XP002772414,**
 • **AFIFI, M.; MAURER, M.; HEHN, T.; TASCHWER, A.; MANOLI, Y.: "An automatic tuning technique for background frequency calibration in gyroscope interfaces based on high order bandpass Delta-Sigma modulators", CIRCUITS AND SYSTEMS (ISCAS), 2015 IEEE INTERNATIONAL SYMPOSIUM ON, 24. Mai 2015 (2015-05-24), XP002772415,**

**Beschreibung**

Die vorliegende Erfindung bezieht sich auf ein Verfahren zur automatischen Frequenzanpassung von Filtern während des Betriebs in geschlossenen Regelschleifen. Solche Filter können insbesondere vorteilhaft beim Betrieb von Drehratensensoren eingesetzt werden. Solche Drehratensensoren finden Anwendung in Fahrerassistenzsystemen, Navigationssystemen und zunehmend in mobilen batteriebetriebenen Geräten wie Smartphones oder Tablet-Computern.

Mikroelektromechanische (MEM) Coriolis-Drehratensensoren (engl. Coriolis Vibratory Gyroscope, CVG) besitzen eine bewegliche mechanische Struktur, welche zu einer periodischen Schwingung angeregt wird. Diese periodische, durch Anregung erzeugte Schwingung wird auch als primäre Schwingung bezeichnet. Erfährt der Sensor eine Drehung um eine Achse senkrecht zu der Primärschwingung oder Primärbewegung, so führt die Bewegung der Primärschwingung zu einer Corioliskraft, die proportional zur Messgröße, d. h. der Winkelgeschwindigkeit, ist. Diese Achse wird als die sensitive Achse des Sensors bezeichnet. Durch die Corioliskraft wird eine zweite, zur Primärschwingung orthogonale Schwingung angeregt. Diese zweite, zur Primärschwingung orthogonale Schwingung wird auch als Sekundärschwingung oder Sekundärbewegung bezeichnet. Die Sekundärschwingung, die auch als Detektionsschwingung bezeichnet wird, kann durch verschiedene Messverfahren erfasst werden, wobei die erfasste Größe als Maß für die auf den Drehratensensor wirkende Drehrate dient. Um die Primärschwingung zu erzeugen, werden unter anderem thermische, piezoelektrische, elektrostatische und induktive Verfahren verwendet, welche in der Technik bekannt sind. Zu der Erfassung der Sekundärschwingung sind piezoelektrische, piezoresistive oder kapazitive Prinzipien Stand der Technik.

Drehratensensoren können auf verschiedene Art und Weise ausgeführt werden. Alle Drehratensensoren haben jedoch gemeinsam, dass sie eine Schwingeinrichtung umfassen, die durch eine Primäranregungseinrichtung in die Primärbewegung versetzbar ist und dass sie eine Sekundärerfassungseinrichtung haben, die eine Sekundärbewegung aufgrund einer auf den Drehratensensor wirkenden Drehrate messen kann. Bei nicht-entkoppelten Sensoren führt ein und dieselbe schwingende Masse sowohl die Primärbewegung als auch die Sekundärbewegung aus. Diese Schwingeinrichtung ist dann derart ausgestaltet, dass sie eine Masse umfasst, die sowohl in der x-Richtung als auch in der y-Richtung bewegbar aufgehängt wird. Ohne Einschränkung der Allgemeinheit wird angenommen, dass die x-Richtung die Richtung der Primärbewegung oder der Primärschwingung ist, und dass die y-Richtung die Richtung der Sekundärbewegung bzw. der Sekundärschwingung ist, und dass die Drehrate auf die Schwingeinrichtung in z- Richtung wirkt.

Die Schwingeinrichtung ist üblicherweise in einen Primärschwinger und einen Sekundärschwinger aufgeteilt. Der Primärschwinger führt eine Schwingung in Primärrichtung durch und ist so mit dem Sekundärschwinger gekoppelt, dass die Primärschwingung auf den Sekundärschwinger übertragen wird. Der Primärschwinger ist idealerweise derart an einem Substrat aufgehängt, dass er sich lediglich in Primärrichtung bewegen kann, nicht aber in Sekundärrichtung. Damit führt eine auf den Primärschwinger wirkende Corioliskraft aufgrund einer Drehrate nicht dazu, dass der Primärschwinger in Sekundärrichtung ausgelenkt wird, da dieser Bewegungsfreiheitsgrad aufgrund seiner Aufhängung für den Primärschwinger nicht existiert. Dagegen ist der Sekundärschwinger derart aufgehängt, dass er sich sowohl in Primärrichtung als auch in Sekundärrichtung bewegen kann. Die Sekundärbewegung führt dazu, dass sich der Sekundärschwinger in Sekundärrichtung bewegt, wobei diese Sekundärbewegung durch die Sekundärerfassungseinrichtung erfassbar ist. Vorzugsweise ist die Sekundärerfassungseinrichtung dabei so ausgebildet, dass sie die Primärbewegung nicht erfasst, die der Sekundärschwinger nur deswegen ausführt, um auf die Corioliskraft sensitiv zu sein. Die Verbindung zwischen den Primärschwinger und dem Sekundärschwinger ist ferner, um eine noch bessere Kopplung zu erreichen, derart ausgebildet, dass zwar die Primärschwingung von dem Primärschwinger auf den Sekundärschwinger übertragen wird, dass jedoch die Sekundärschwingung nicht auf den Primärschwinger zurück übertragen wird.

Drehratensensoren detektieren Drehraten um eine definierte sensitive Achse basierend auf dem Coriolis-Effekt. Der Drehratensensor besteht wie oben ausgeführt aus zwei Massen, der primären sowie der sekundären. Um eine Drehrate mit Hilfe des Coriolis-Effekts detektieren zu können, muss die gesamte Masse in Bewegung versetzt werden. Die primäre Masse, in der die sekundäre Masse aufgehängt ist, wird z. B. durch elektrostatische Aktuierung mit ihrer Resonanzfrequenz in eine konstante Schwingung versetzt. Durch eine Rotation des Sensors um die sensitive Achse wirkt auf die sekundäre Masse orthogonal zur primären Achse gemäß der nachfolgenden Gleichung (1) die Coriolis Kraft $F_c$ so, dass die sekundäre Masse ausgelenkt wird.

$$\vec{F_c} = -2m\vec{\Omega} \times \vec{v}_p \tag{1}$$

Dabei ist m die Masse, $\Omega$ die Drehrate und $v_p$ die Geschwindigkeit der primären Masse. Die sekundäre Masse ist idealerweise mechanisch so aufgehängt, dass sie nur orthogonal zur primären Oszillation auslenken kann. Eine große Amplitude der Primärschwingung ist wünschenswert, um eine hohe Empfindlichkeit zu erreichen. Die Primärmasse wird hierbei üblicherweise resonant angeregt und die Amplitude der Schwingung mittels einer automatischen Verstärkungsregelung (Automatic Gain Control, AGC) geregelt, wie dies aus dem Artikel T. Northemann, M. Maurer, S.

Rombach, A. Buhmann, Y. Manoli: "Drive and sense interface for gyroscopes based on bandpass sigma-delta modulators", Proc. IEEE Int. Circuits and Systems (ISCAS) Symp, pages 3264-3267, 2010, bekannt ist.

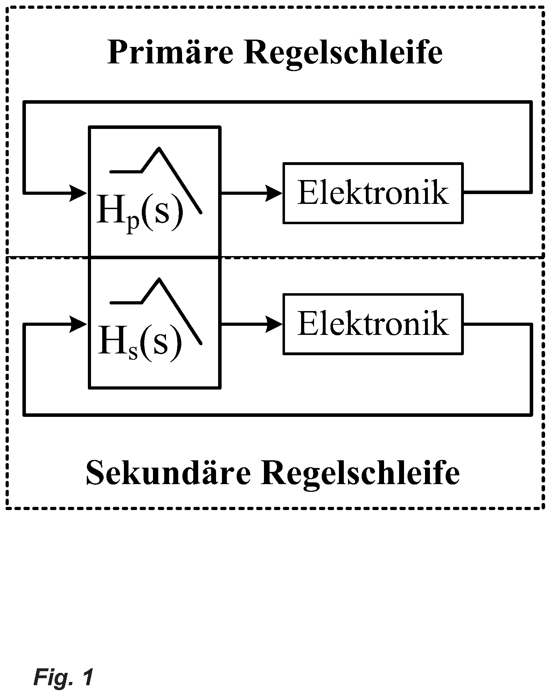

Figur 1 zeigt schematisch einen Drehratensensor mit einer primären Regelschleife für den Antrieb und einer sekundären Regelschleife für das Auslesen des Signals. Um eine hohe Linearität, große Bandbreiten und eine verringerte Empfindlichkeit gegenüber Prozessschwankungen zu erreichen, werden diese Sensoren, wie in Figur 1 zu sehen, sowohl auf der primären als auch auf der sekundären Seite rückgekoppelt betrieben. In der sekundären Regelschleife wird gemäß der nachfolgenden Gleichung (2) durch das Aufbringen einer rückstellenden kapazitiven Kraft die wirkende Coriolis Kraft $\vec{F}_C$ kompensiert:

$$\vec{F}_C = \vec{F}_{es} \tag{2}$$

Dadurch bleibt die sekundäre Masse in der Ruheposition und die generierte Kraft $\vec{F}_{es}$ bildet ein direktes Maß für die auf das System einwirkende Drehrate.

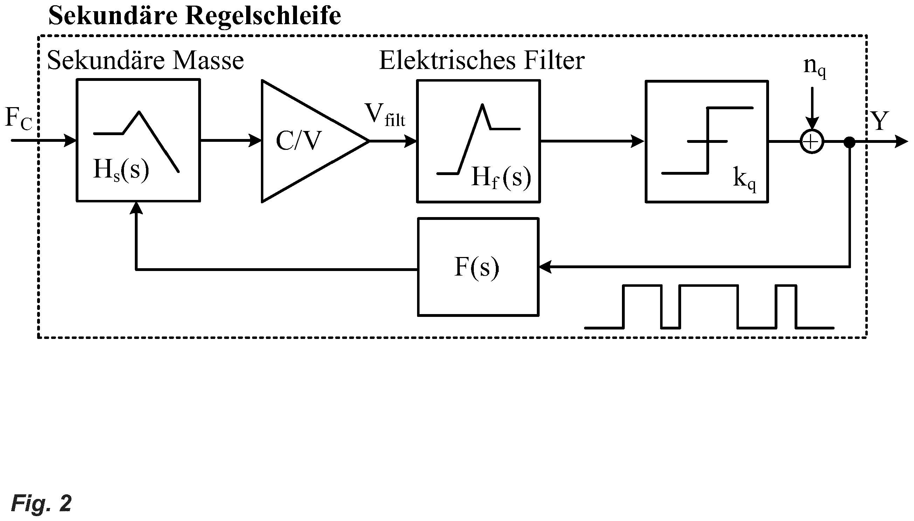

Das erforderliche Kompensationssignal wird üblicherweise durch die Einbettung des Sensors in eine geschlossene Regelschleife eines Delta-Sigma-Modulators (nachfolgend auch abgekürzt als $\Delta\Sigma M$) erzeugt. Figur 2 zeigt schematisch ein vereinfachtes Blockschaltbild einer sekundären Regelschleife zum Betrieb eines Drehratensensors basierend auf der Delta-Sigma-Modulation. Auf diese Weise wird das Ausgangssignal direkt hochauflösend digitalisiert und es wird eine hohe Linearität erreicht.

$\Delta\Sigma M$ basieren unter anderem auf einer Rauschformung. Dabei wird das am Ausgang entstehende Quantisierungsrauschen $n_q$ durch Filter, die innerhalb des Modulators vorgesehen sind, im Signalband unterdrückt und zu anderen Frequenzen hin verschoben. Bei der Realisierung eines elektromechanischen $\Delta\Sigma M$ wird häufig neben dem eigentlichen mechanischen Sensorelement $H_s(s)$ auch ein zusätzliches elektronisches Filter für die Rauschformung genutzt. Dieses Filter $H_f(s)$ ist typischerweise als Bandpassfilter ausgelegt.

Daraus ergeben sich die Rausch-Transferfunktion (NTF) entsprechend der nachfolgenden Gleichung (3) und die Signal-Transferfunktion (STF) nach Gleichung (4).

$$NTF = \frac{Y}{n_q} = \frac{1}{1 + F(s)k_q H_s(s)H_f(s)} \tag{3}$$

$$STF = \frac{Y}{F_C} = \frac{k_q H_s(s)H_f(s)}{1 + F(s)k_q H_s(s)H_f(s)} \approx \frac{1}{F(s)} \tag{4}$$

Dabei bedeuten Y das Ausgangssignal des $\Delta\Sigma M$, $k_q$ eine Quantisierungskonstante, F(s) die Übertragungsfunktion der Rückkopplung, $H_f(s)$ die Übertragungsfunktion des elektrischen Filters, $H_s(s)$ die Übertragungsfunktion der sekundären Masse.

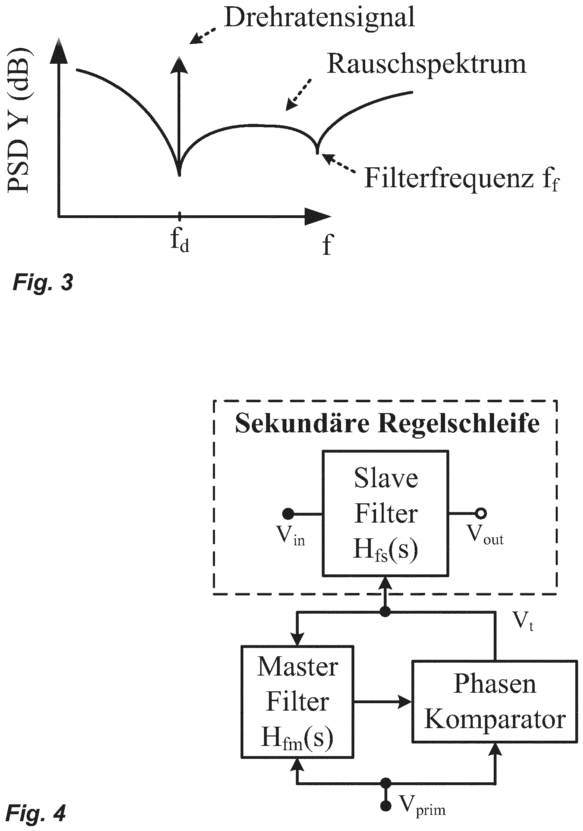

Um das bestmögliche Signal-zu-Rauschverhältnis (SNR) zu erreichen, muss die Resonanzfrequenz $f_f$ des elektrischen Filters $H_f(s)$ sehr genau mit der primären Resonanzfrequenz des Drehratensensors $f_d$, auf der das Drehratensignal moduliert ist, übereinstimmen. Das typische Leistungsspektrum des Ausgangs Y eines $\Delta\Sigma M$ ist in Figur 3 für den Fall, dass die Frequenzen $f_d$ und $f_f$ nicht übereinstimmen, dargestellt.

Insbesondere im Fall von zeitkontinuierlichen Filtern $H_f(s)$, die sehr energieeffizient implementiert werden können, ergeben sich große Schwankungen der Filter-Resonanzfrequenz $f_f$ bei der Herstellung und unter dem Einfluss von Temperaturänderungen. Hinzu kommt, dass die primäre Resonanzfrequenz $f_d$ von Drehratensensoren durch Prozessvariationen ebenfalls stark variieren kann. Diese Schwankungen führen dazu, dass die Sensorausleseschaltungen zum einen initial eingestellt werden muss und zum anderen Schwankungen während des Betriebs ausgeglichen werden müssen.

Um eine Verringerung des SNR zu vermeiden, muss die Einstellung der Frequenz $f_f$ sehr genau sein. Das bedeutet, der Fehler zwischen Filter- und Sensorresonanzfrequenz sollte geringer als die Bandbreite (BW) des Drehratensignals sein. Aus typischen Werten für die Bandbreite BW = 50 Hz und Sensorresonanzfrequenzen $f_d$ = 10 kHz ergibt sich beispielsweise eine hohe geforderte relative Genauigkeit von 0,5 %.

Im Stand der Technik sind bereits verschiedene Konzepte zur Einstellung eines Filters in einem $\Delta\Sigma M$ während des Betriebs bekannt. Die nachfolgenden Beispiele beziehen sich dabei sowohl auf rein elektrische $\Delta\Sigma M$ zur Analog-Digital-Wandlung, bei denen eine sehr ähnliche Problemstellung vorliegt, als auch auf elektromechanische $\Delta\Sigma M$ für Drehratensensoren.

Beispielsweise offenbart die Druckschrift Tsividis, Y., "Integrated continuous-time filter design - an overview," Solid-State Circuits, IEEE Journal of, vol.29, no.3, pp. 166,176, March 1994, das so genannte Master-Slave-Prinzip, bei dem zwei möglichst gut aufeinander abgestimmte Filter eingesetzt werden. Der prinzipielle Aufbau zum Nachführen der Filterfrequenz mit dem Master-Slave-Prinzip ist in Figur 4 gezeigt.

Ein Filter $H_{fs}(s)$ (Slave) arbeitet dabei innerhalb der Ausleseschaltung, während das andere Filter $H_{fm}(s)$ (Master) außerhalb mit Hilfe der primären Resonanzfrequenz und eines Phasenkomparators eingestellt werden kann. Ausgehend von der Annahme, dass sich beide Filter gleich verhalten, kann das Signal $V_t$ nicht nur für das Master-Filter, sondern auch für das Slave-Filter genutzt werden.

Dieses bekannte Verfahren ist jedoch nicht anwendbar, wenn das eingesetzte elektrische Filter eine nicht zu vernachlässigende Nicht-Linearität aufweist. Vor allem zeitkontinuierliche Filter, deren Zeitkonstanten nicht durch Widerstands- und Kapazitätsverhältnisse (RC), sondern durch die Transkonduktanz von Transistoren und Kapazitäten ($G_m$-C) definiert werden, stellen hier ein Problem dar. $G_m$-C Filter werden im Allgemeinen eingesetzt, da sie sehr energieeffizient implementiert werden können. Sie zeigen aber eine Abhängigkeit der Transkonduktanz $g_m$ (und somit ebenfalls der Resonanzfrequenz) von der Eingangsspannung. Für den Betrieb innerhalb der sekundären Regelschleife ist die Abhängigkeit zu vernachlässigen, da nach Figur 2 und gemäß der nachfolgenden Gleichung (5) das Signal am Eingang des Filters $V_{filt}$ bei der Resonanzfrequenz $f_f$ durch den Gesamtregelkreis mit der Verstärkung des Filters $H_f(s)$ unterdrückt wird:

$$V_{filt} = \frac{F_C - n_q}{\frac{1}{H_S(s)} + H_f(s)} \hspace{4cm} (3)$$

Wird allerdings, wie dies bei dem Master-Slave-Verfahren geschieht, die eigentliche Frequenzanpassung außerhalb der Ausleseschleife durchgeführt, ist dies problematisch. Denn wenn ein Signal mit der gewünschten Resonanzfrequenz direkt an den Eingang eines solchen Filters angelegt wird, verursacht dies, durch die hohen Signalamplituden im Filter bzw. die hohe Verstärkung bei Resonanz, eine starke Verstimmung der Filterfrequenz. Eine zuverlässige Einstellung ist nicht mehr möglich.

Darüber hinaus wird die Genauigkeit dieses bekannten Verfahrens insbesondere durch die begrenzte Übereinstimmung der beiden verwendeten Filter auf einen häufig nicht zu tolerierenden Wert limitiert. Weiterhin ist der Flächenbedarf bei einer Implementierung als integrierte Schaltung relativ hoch, da zusätzlich zur Schaltung für die automatische Frequenzanpassung ein weiteres analoges Filter benötigt wird.

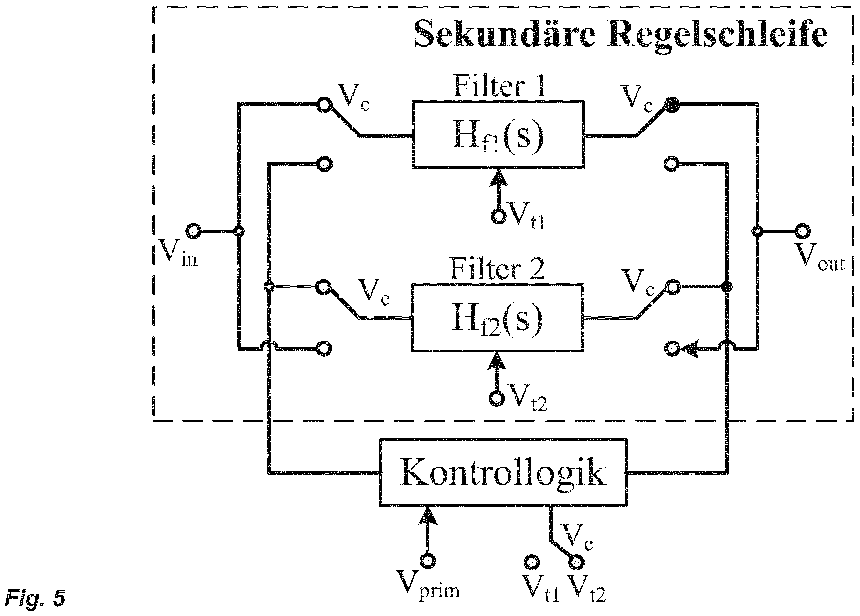

Ein weiteres bekanntes Konzept, das auf zwei getrennten Filtern basiert, allerdings keine genaue Übereinstimmung der Filter erfordert, wird in dem Artikel Afifi, M.; Maurer, M.; Hehn, T.; Taschwer, A.; Manoli, Y., "An automatic tuning technique for background frequency calibration in gyroscope interfaces based on high order bandpass Delta-Sigma modulators," Circuits and Systems (ISCAS), 2015 IEEE International Symposium on, pp.1730,1733, 24-27 May 2015, für den Einsatz in einer Ausleseschaltung für Drehratensensoren beschrieben. Wie in Figur 5 dargestellt, wird bei diesem Konzept ebenfalls ein Filter innerhalb der Ausleseschaltung genutzt, während das andere außerhalb mit Hilfe der primären Resonanzfrequenz eingestellt wird. Im Gegensatz zur ersten Methode werden beide Filter aber periodisch ausgetauscht, so dass die Ausleseschaltung nur für einen kurzen Moment unterbrochen werden muss. Gleichzeitig wird davon ausgegangen, dass das Filter in der Ausleseschaltung während einer Periode des Austauschzyklus keine signifikante Änderung der Resonanzfrequenz erfährt.

Dieses Prinzip der periodisch ausgetauschten Filter wird in der Druckschrift Tsividis, Y., "Self-tuned filters," Electronics Letters, vol.17, no.12, pp.406,407, June 11 1981, ebenfalls bereits für die allgemeine Anwendung bei zeitkontinuierlichen Filtern beschrieben.

Allerdings treten bei dem Konzept der periodisch ausgetauschten Filter dieselben Probleme aufgrund der Nichtlinearität der Filter auf wie bei dem Master-Slave-Konzept. Darüber hinaus muss das Filter periodisch abgekoppelt werden, somit besteht die Gefahr, dass die Funktionalität der sekundären Regelschleife beeinträchtigt wird. Weiterhin ist der Flächenbedarf bei einer Implementierung als integrierte Schaltung auch bei dieser bekannten Anordnung relativ hoch, da zusätzlich zur Schaltung für die automatische Frequenzanpassung ein weiteres analoges Filter benötigt wird.

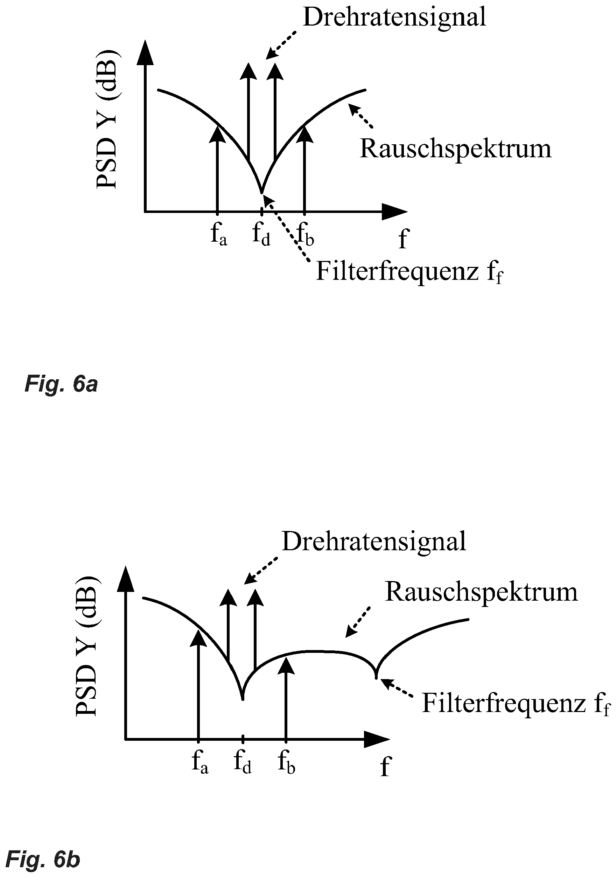

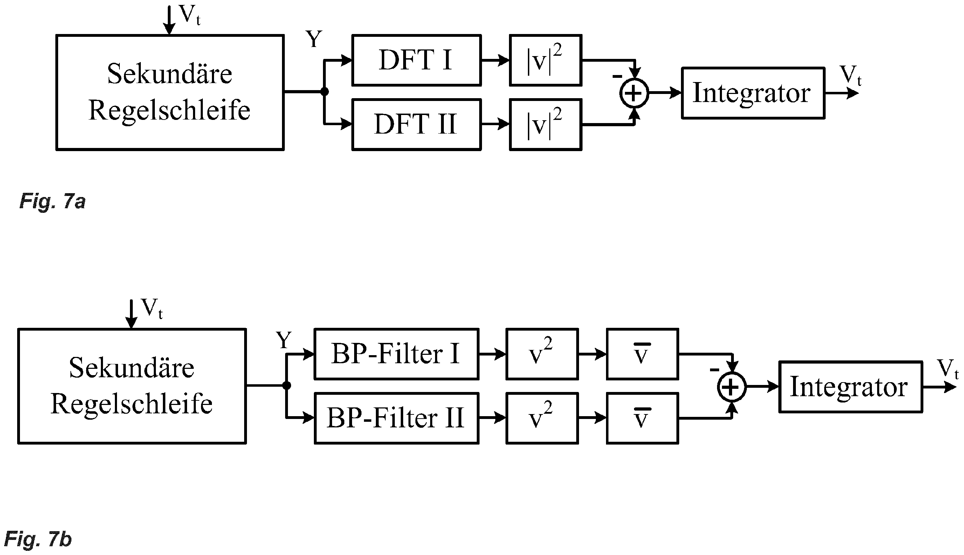

Weiterhin ist bekannt, die Leistung zweier spektraler Punkte am Ausgang des $\Delta\sum M$ zu betrachten. In der Druckschrift Huanzhang Huang; Lee, E.K.F., "Frequency and Q tuning techniques for continuous-time bandpass sigma-delta modulator," Circuits and Systems, 2002. ISCAS 2002. IEEE International Symposium on, vol.5, no., pp.V-589,V-592 vol.5, 2002, wird das Prinzip einer Schaltung zur Frequenzanpassung des Filters in rein elektrischen $\Delta\sum M$ beschrieben. Es werden zwei unterschiedliche Ansätze zur Bestimmung der Rauschleistung am Ausgang des Modulators an zwei diskreten Punkten $f_a$ bzw. $f_b$, die leicht ober- bzw. unterhalb der eigentlichen Signalfrequenz um $f_d$ herum liegen, vorgestellt. Da das elektrische Filter die Rauschleistung an diesen diskreten Frequenzen in Abhängigkeit der Lage seiner Resonanzfrequenz unterschiedlich beeinflusst, kann durch den Betrag der beiden Rauschleistungen bestimmt werden, ob die Filterresonanzfrequenz zu hoch oder zu niedrig ist. In Figur 6a ist das Prinzip anhand des Spektrums des Ausgangs Y der sekundären Regelschleife des $\Delta\sum M$ dargestellt, wenn $f_d$ und $f_f$ übereinstimmen. Entsprechend zeigt Figur 6b den Fall, wenn $f_f$ zu hoch liegt. Die diskreten Signalkomponenten $f_a$ und $f_b$ im Spektrum des Ausgangs $Y$ werden verglichen, um die aktuelle Filterfrequenz einzuschätzen. Gemäß einem ersten Ansatz dieser bekannten Lösung wird zur Auswertung eine diskrete Fouriertransformation (DFT) an den Punkten $f_a$ und $f_b$ mittels digitaler Signalverarbeitung gebildet. Dieses Konzept ist in Figur 7a schematisch dargestellt.

Gemäß einem zweiten Ansatz der Druckschrift Huanzhang Huang; Lee, E.K.F., "Frequency and Q tuning techniques for continuous-time bandpass sigma-delta modulator," Circuits and Systems, 2002. ISCAS 2002. IEEE International Symposium on , vol.5, pp.V-589,V-592 vol.5, 2002, werden die zu betrachtenden Frequenzen, wie in Figur 7b skizziert, mittels zweier zusätzlicher sehr schmalbandiger digitaler Filter herausgefiltert. Anschließend wird die Leistung beider Signale berechnet und verglichen. Ein digitaler Regler steuert jeweils entsprechend dem Vergleichsergebnis das Filter nach.

Nachteilig ist diese Lösung, wenn die Ausleseschleife mehr als nur ein Filter beinhaltet. Dies ist typischerweise bei elektromechanischen $\Delta\Sigma M$ für Drehratensensoren der Fall, da neben dem elektrischen Filter auch das mechanische Element zur Filterung nach Gleichung (4) eingesetzt wird. Dies hat zur Folge, dass die NTF und somit das Rauschen am Ausgang von zwei unabhängigen Filterelementen bestimmt wird. Es ist jedoch nicht möglich, zu unterscheiden, welches der beiden Filter eingestellt werden muss.

Bei diesem bekannten Verfahren werden außerdem nur zwei diskrete Frequenzkomponenten betrachtet, die außerhalb des Signalbandes liegen müssen. Dadurch ist die Genauigkeit der Regelung limitiert und viele Messungen müssen gemittelt werden. Eine Mittelung mehrerer Messungen führt allerdings wiederum zu einem langsameren Verhalten der Frequenzanpassung. Dies kann insbesondere bei Applikationen, die schnellen Temperaturschwankungen ausgesetzt sind, nicht tolerierbar sein. Noch gravierender ist, dass, durch die begrenzte Frequenzselektivität, ein Signal im Signalband zu Störungen der Filterregelschleife führt.

Weiterhin wird in der Druckschrift Huanzhang Huang; Lee, E.K.F., "Frequency and Q tuning techniques for continuous-time bandpass sigma-delta modulator," Circuits and Systems, 2002. ISCAS 2002. IEEE International Symposium on , vol.5, pp.V-589,V-592 vol.5, 2002, angegeben, dass beide Implementierungsvarianten in einem ähnlichen Platzbedarf resultieren. Ausgehend von der zweiten Variante ergibt sich aber auch hier mit zwei zusätzlichen digitalen Bandpassfiltern, zwei Multiplizieren und zwei Integrierern ein ebenfalls hoher Flächenbedarf in Bezug auf das einzustellende Filter.

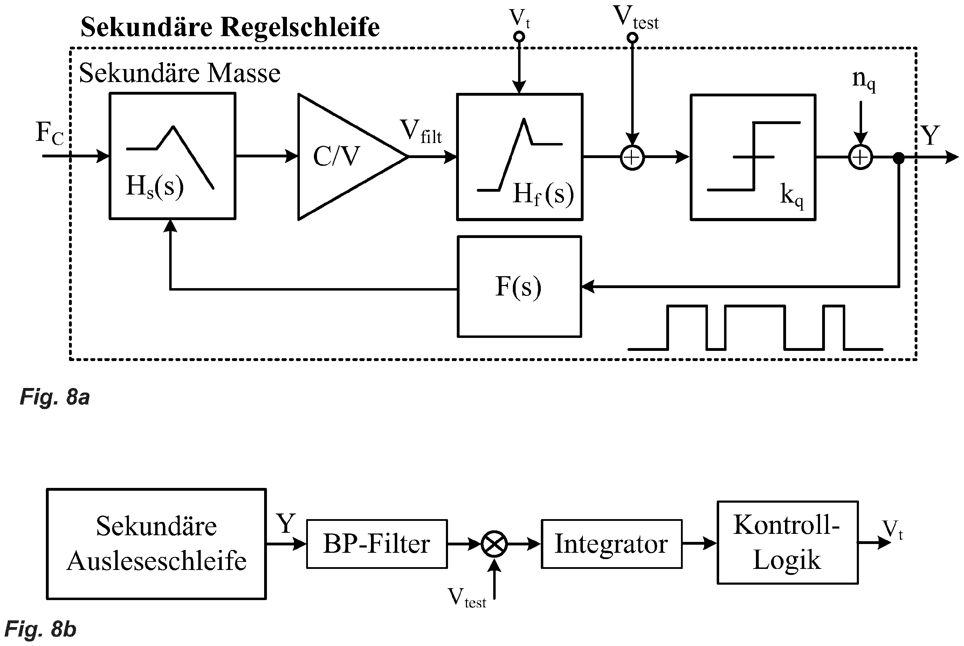

Eine weitere bekannte Lösung basiert auf dem Einspeisen von Testsignalen. Wie in der Druckschrift Yun-Shiang Shu; Bang-Sup Song; Bacrania, K., "A 65nm CMOS CT $\Delta\Sigma$ Modulator with 81dB DR and 8MHz BW Auto-Tuned by Pulse Injection," Solid-State Circuits Conference, 2008. ISSCC 2008. Digest of Technical Papers. IEEE International, pp.500,631, 3-7 Feb. 2008, beschrieben und in Figur 8a für einen elektromechanischen $\Delta\Sigma M$ dargestellt, wird bei dieser Lösung nach dem Filter in einem rein elektrischen $\Delta\Sigma M$ ein Testsignal $V_{test}$ mit genau einer Frequenz in die Regelschleife eingespeist. Dann wird geprüft, wie das Testsignal von der Filter-Transferfunktion am digitalen Ausgang Y des Modulators unterdrückt wird. Je nach Phasenlage und Größe des verbleibenden Testsignals am Ausgang $Y$ kann darauf rückgeschlossen werden, ob die Filterresonanzfrequenz $f_f$ zu hoch oder zu niedrig liegt. Ein digitaler Regler steuert dementsprechend das Filter nach. Figur 8b zeigt eine solche bekannte Schaltung zum Auswerten der eingespeisten Testsignale.

Weiterhin beschreibt die Patentschrift US 7,042,375 B2 ein Prinzip, bei dem statt genau einer Frequenz ein breitbandiges Spektrum (Dither) als Testsignal $V_{test}$ genutzt wird. Die Auswertung des Signals am Ausgang Y erfolgt ähnlich wie in den Figuren 7b oder 8b dargestellt.

Die Druckschrift US 7,324,028 B2 beschreibt das Einspeisen von Testsignalen vor oder nach dem Quantisierer und zusätzlich das Überbrücken einzelner Filterelemente.

Weiterhin ist aus Ezekwe, C.D.; Boser, B.E., "A Mode-Matching $\Delta\Sigma$ Closed-Loop Vibratory-Gyroscope Readout Interface with a 0.004°/s/√Hz Noise Floor over a 50Hz Band," in Solid-State Circuits Conference, 2008. ISSCC 2008. Digest of Technical Papers. IEEE International, vol., no., pp.580-637, 3-7 Feb. 2008, bekannt, die Testsignale nicht wie in Figur 8a gezeigt nach dem Filterelement, sondern vor dem Filterelement $H_f(s)$ in die Ausleseschleife einzuspeisen. Dadurch kann nicht das elektrische Filter $H_f(s)$, sondern die Resonanzfrequenz der sekundären Masse $H_s(s)$ eingestellt werden. Die Besonderheit bei dieser bekannten Implementierung und dem zugrunde liegenden Konzept aus der Druckschrift DE 19910 415 A1 ist, dass die Testsignale differentiell um die eigentliche Resonanzfrequenz herum und nicht innerhalb des Signalbands liegen. Das prinzipielle Vorgehen ist aber auch für die Einstellung des elektrischen Filters $H_f(s)$ denkbar.

Auch diese Lösung ist nachteilig, wenn die Ausleseschleife mehr als nur ein Filter beinhaltet. Wie erwähnt, ist dies typischerweise bei elektromechanischen $\Delta\Sigma M$ für Drehratensensoren der Fall, da neben dem elektrischen Filter auch das mechanische Element zur Filterung nach Gleichung (4) eingesetzt wird. Dies hat zur Folge, dass die NTF und somit das Rauschen am Ausgang von zwei unabhängigen Filterelementen bestimmt wird. Es ist jedoch nicht möglich, zu unterscheiden, welches der beiden Filter eingestellt werden muss.

Ein erheblicher Nachteil von einem Teil der Verfahren, die Testsignale verwenden, ist, dass das Testsignal direkt im Signalband liegt und aufgrund der limitierten Auflösung nie perfekt unterdrückt wird. Dadurch kann das verbleibende Testsignal den Betrieb der eigentlichen Ausleseschleife stören. Des Weiteren erhöht sich bei dieser Methode die Zeit, bis die sekundäre Regelschleife nach dem Start genutzt werden kann. Im Gegensatz zu den übrigen erläuterten Verfahren bedeutet bei diesen Varianten nämlich ein falsch eingestelltes Filter nicht nur, dass das SNR schlechter ist, sondern auch, dass das Testsignal nicht unterdrückt wird. Es kann somit nicht von einem möglichen Drehratensignal unterschieden werden. Bei der bekannten Implementierung gemäß Ezekwe, C.D.; Boser, B.E., "A Mode-Matching $\Delta\Sigma$ Closed-Loop Vibratory-Gyroscope Readout Interface with a 0.004°/s/VHz Noise Floor over a 50Hz Band," in Solid-State Circuits Conference, 2008. ISSCC 2008. Digest of Technical Papers. IEEE International, vol., no., pp.580-637, 3-7 Feb. 2008, und DE 19910415 A1 sollten die Signale außerhalb der Bandbreite des Drehratensignals liegen. Dadurch ergibt sich ein Kompromiss zwischen maximaler Bandbreite und Genauigkeit der Regelung.

Darüber hinaus kommt zu dem Flächenbedarf für die Auswertung der Testsignale je nach Implementierung ein bedeutender zusätzlicher Bedarf an Fläche für die Generierung der Testsignale und die Einspeisung in die Ausleseschleife hinzu, so dass bei einer Implementierung als integrierte Schaltung von einem nachteilig hohen Flächenbedarf auszugehen ist.

Keine der bisher bekannten Lösungen erfüllt somit alle Anforderungen an eine automatische Frequenzanpassung von elektrischen Filtern während des Betriebs in geschlossenen Regelschleifen hinsichtlich der Anwendbarkeit, der Funktionalität und des Flächenbedarfs einer Implementierung als integrierte Schaltung.

Es besteht daher ein Bedürfnis nach einem verbesserten Verfahren zur automatischen Frequenzanpassung von Filtern, das eine zuverlässige hochauflösende Detektion eines Drehratensignals ermöglicht.

Dafür muss das notwendige initiale Einstellen bzw. das kontinuierliche Nachführen des elektrischen Filterelements in einer geschlossenen Ausleseschleife, wie in Figur 2 dargestellt, realisiert werden. Die Frequenzanpassung soll bei minimal möglichem Energie- und Platzverbrauch sowie kurzer Startzeit erfolgen. Die Schaltung muss die Resonanzfrequenz $f_f$ des elektrischen Filters $H_f(s)$, während des Betriebs der Ausleseschaltung und ohne diese zu unterbrechen, an die primäre Resonanzfrequenz des Sensors $f_d$ anpassen. Dadurch werden auftretende Änderungen in den Resonanzfrequenzen $f_d$ oder $f_f$, z.B. durch eine Änderung der Temperatur, kompensiert. Dies impliziert, dass der Einstellprozess nicht von möglichen Drehratensignalen gestört werden darf. Des Weiteren darf die Frequenzanpassung nicht durch die mechanische Transferfunktion des Sensorelements $H_s(s)$ beeinflusst werden. Die maximale Abweichung zwischen $f_d$ und $f_f$ muss im Bereich der Bandbreite des Drehratensignals liegen.

Diese Aufgabe wird durch den Gegenstand des unabhängigen Patentanspruchs gelöst. Vorteilhafte Weiterbildungen der vorliegenden Erfindung sind Gegenstand der Unteransprüche.

Die vorliegende Erfindung basiert auf der Idee, ein System zur Frequenzanpassung des elektrischen Filters $H_f(s)$ anzugeben, das eine erste Komponente zur groben initialen Angleichung der Frequenzen $f_f$ an $f_d$ und eine zweite Komponente zur Frequenzanpassung, die während des Betriebs im Hintergrund arbeitet, aufweist.

Die Komponente zur groben Angleichung ist insbesondere notwendig um die Schwankungen bei der Herstellung des Drehratensensors und damit die Variation der primären Resonanzfrequenz $f_d$ auszugleichen. Dazu wird das Steuersignal des in der primären Regelschleife vorhandenen Oszillators genutzt. Dieser Oszillator wird von den Komponenten innerhalb der primären Regelschleife auf die primäre Resonanzfrequenz des Drehratensensors abgestimmt. Durch eine Angleichung der Steuerungscharakteristik des Oszillators an die Frequenzsteuerung des elektrischen Filters in der sekundären Regelschleife, kann somit, ähnlich wie bei dem oben beschriebenen Master-Slave-Prinzip, eine grobe Angleichung der Frequenzen erfolgen. Allerdings ist im Gegensatz zu der bekannten Lösung insbesondere kein zusätzliches Filter und im Allgemeinen ein nur sehr geringer zusätzliche Schaltungsaufwand erforderlich.

Die zusätzlich im Hintergrund mitlaufende Frequenzanpassung ist notwendig, um die geforderte hohe Genauigkeit zu erreichen. Das Prinzip der Frequenzanpassung basiert auf der Bewertung der Rauschformung der geschlossenen Regelschleife am Eingang des elektrischen Filters $V_{filt}$ in einem differentiellen Band um die primäre Resonanzfrequenz $f_d$ herum.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einzelne Merkmale oder Merkmalskombinationen aus den gezeigten und beschriebenen Ausführungsformen für sich genommen eigenständige erfinderische oder erfindungsgemäße Lösungen darstellen.

Es zeigen:

Fig. 1    eine schematische Prinzipdarstellung eines Drehratensensors basierend auf dem Corioliseffekt;

Fig. 2    eine schematische Darstellung einer sekundären Regelschleife basierend auf dem Prinzip der Delta-Sigma-Modulation zum Betrieb eines Drehratensensors;

Fig. 3    den Verlauf der spektralen Leistungsdichte des Ausgangs der sekundären Regelschleife bei Fehlanpassung zwischen der primären Resonanzfrequenz und der Filterfrequenz des Schleifenfilters;

**Fig. 4**     eine erste bekannte Anordnung zum Nachführen der Filterfrequenz;

**Fig. 5**     eine zweite bekannte Anordnung zum Nachführen der Filterfrequenz;

**Fig. 6a**     den Verlauf der spektralen Leistungsdichte des Ausgangs der sekundären Regelschleife bei Übereinstimmung zwischen der primären Resonanzfrequenz und der Filterfrequenz des Schleifenfilters;

**Fig. 6b**     den Verlauf der spektralen Leistungsdichte des Ausgangs der sekundären Regelschleife bei Fehlanpassung zwischen der primären Resonanzfrequenz und der Filterfrequenz des Schleifenfilters;

**Fig. 7a**     eine weitere bekannte Anordnung zum Nachführen der Filterfrequenz;

**Fig. 7b**     eine weitere bekannte Anordnung zum Nachführen der Filterfrequenz;

**Fig. 8a**     eine Prinzipdarstellung einer sekundären Regelschleife mit eingespeisten Testsignalen;

**Fig. 8b**     eine Prinzipdarstellung einer Schaltung zum Auswerten der in die sekundäre Regelschleife eingespeisten Testsignale;

**Fig. 9a**     den Verlauf der spektralen Leistungsdichte des Eingangs des elektrischen Filters der sekundären Regelschleife sowie die erfindungsgemäß ausgewerteten Frequenzbänder bei Übereinstimmung zwischen der primären Resonanzfrequenz und der Filterfrequenz des Schleifenfilters;

**Fig. 9b**     den Verlauf der spektralen Leistungsdichte des Eingangs des elektrischen Filters der sekundären Regelschleife sowie die erfindungsgemäß ausgewerteten Frequenzbänder bei Fehlanpassung zwischen der primären Resonanzfrequenz und der Filterfrequenz des Schleifenfilters;

**Fig. 10**     eine schematische Prinzipdarstellung eines Drehratensensors basierend auf dem Corioliseffekt mit einer Frequenzanpassungsschaltung gemäß einer beispielhaften Ausführungsform der vorliegenden Erfindung.

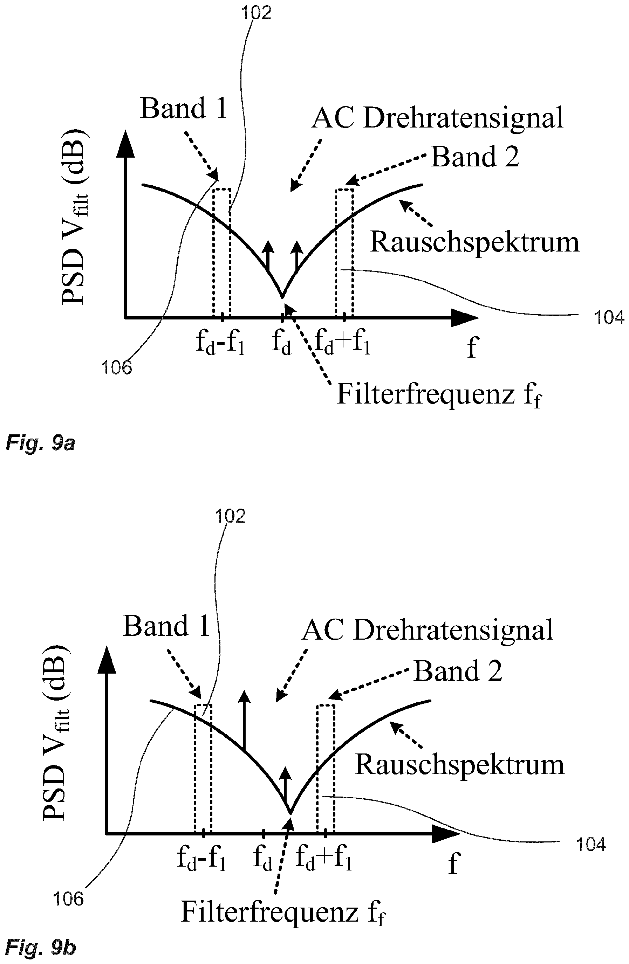

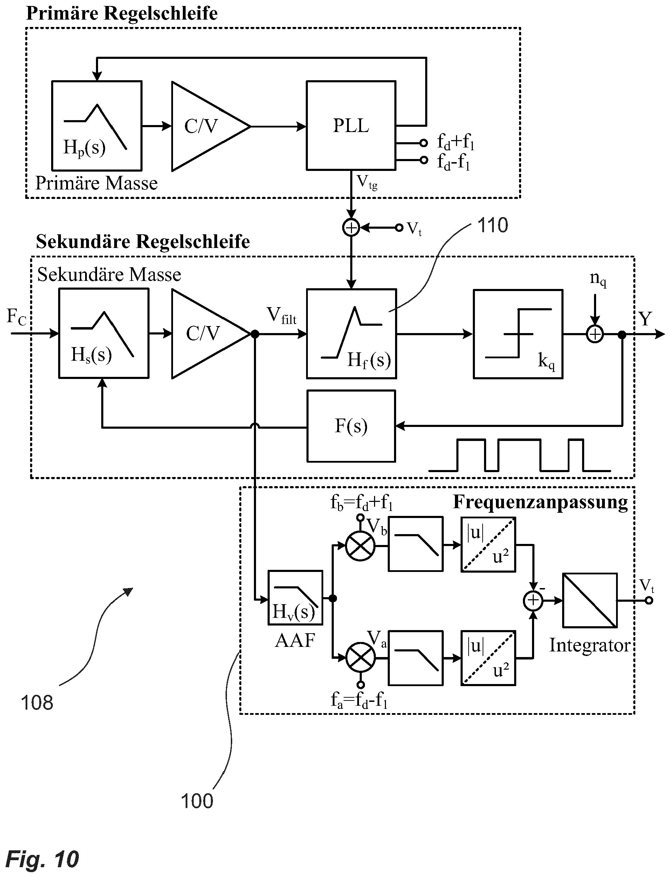

Mit Bezug auf die Figuren 9 und 10 wird eine vorteilhafte Ausführungsform der vorliegenden Erfindung nachfolgend näher erläutert. Gemäß der vorliegenden Erfindung wird zum Anpassen der Filterfrequenz $f_f$ des Schleifenfilters $H_f(s)$ 110 an die Resonanzfrequenz $f_d$ der Primärschwingung das in das Schleifenfilter eingespeiste Signal $V_{filt}$ abgegriffen und in eine Frequenzanpassungsschaltung 100 eingespeist. In der gezeigten Ausführungsform umfasst das System zur Frequenzanpassung des elektrischen Filters $H_f(s)$ eine Komponente zur groben initialen Angleichung der Frequenzen $f_f$ an $f_d$ und eine Komponente zur Frequenzanpassung, die während des Betriebs im Hintergrund arbeitet.

Die Komponente zur groben Angleichung ist insbesondere notwendig, um die Schwankungen bei der Herstellung des Drehratensensors und damit die Variation der primären Resonanzfrequenz $f_d$ auszugleichen. Dazu wird das Steuersignal des in der primären Regelschleife vorhandenen Oszillators der phasenverriegelten Regelschleife (Phase Locked Loop, PLL) genutzt. Dieser Oszillator wird von den Komponenten innerhalb der primären Regelschleife auf die primäre Resonanzfrequenz des Drehratensensors abgestimmt. Durch eine Angleichung der Steuerungscharakteristik des Oszillators an die Frequenzsteuerung des elektrischen Filters in der sekundären Regelschleife, kann somit z. B. bei Betriebsbeginn eine grobe Angleichung der Frequenzen $f_f$ und $f_d$ erfolgen.

Um die geforderte hohe Genauigkeit zu erreichen, schlägt die vorliegende Erfindung eine zusätzlich im Hintergrund mitlaufende Frequenzanpassung vor. Das erfindungsgemäße Prinzip der Frequenzanpassung basiert dabei auf einer Bewertung der Rauschformung der geschlossenen Regelschleife am Eingang des elektrischen Filters $V_{filt}$ in einem differentiellen Band um die primäre Resonanzfrequenz $f_d$ herum.

Die Figuren 9a und 9b zeigen das Spektrum (Leistungsdichtespektrum, power spectrum density, PSD) des Signals $V_{filt}$ in Abhängigkeit von der Frequenz f. Figur 9a stellt dabei die zu betrachtenden Frequenzkomponenten für $f_d = f_f$ schematisch dar, während Figur 9b sich auf den Fall bezieht, dass gilt $f_d < f_f$. Erfindungsgemäß werden jeweils in einem ersten Frequenzband 102 und in einem zweiten Frequenzband 104, die symmetrisch um die Resonanzfrequenz $f_d$ angeordnet sind, die Werte für das Leistungsdichtespektrum des Signals $V_{filt}$ miteinander verglichen. Im Fall, dass $f_d = f_f$, verläuft die Kurve 106 symmetrisch mit Bezug auf die Resonanzfrequenz $f_d$ der Primärschwingung und die Differenz der Werte für das Leistungsdichtespektrum des Signals $V_{filt}$ verschwindet. Demgegenüber verläuft die Kurve 106 unsymmetrisch mit Bezug auf die die Resonanzfrequenz $f_d$ der Primärschwingung, wenn $f_d \neq f_f$. Figur 9b zeigt den Fall, dass $f_d < f_f$. Für eine zu niedrige Filterfrequenz verschiebt sich die Lage der Frequenzbänder 102, 104 mit Bezug auf die Kurve 106 entsprechend in die andere Richtung.

Bildet man in diesem Fall ein Differenzsignal, so ist dieses ungleich Null und kann dazu verwendet werden, ein Anpassungssignal für den Steuereingang des Schleifenfilters zu erzeugen. Mithilfe dieses Vergleichs kann also die Lage der aktuellen Filterfrequenz mit Bezug auf die Resonanzfrequenz der Primärschwingung eingeschätzt werden.

Wie mit Bezug auf Figur 2 oben bereits erläutert, hängt das Signal $V_{filt}$ wie durch die Gleichung (5) beschrieben von der Corioliskraft $F_C$, dem Quantisierungsrauschen $n_q$ sowie den Filterfunktionen $H_s(s)$ und $H_f(s)$ der sekundären Masse beziehungsweise des Schleifenfilters ab.

Im Gegensatz zum Ausgangssignal Y des $\Delta\Sigma M$ werden in vorteilhafter Weise am Eingang des elektrischen Filters $V_{filt}$ sowohl das Quantisierungsrauschen $n_q$ als auch das Drehratensignal $F_c$ durch das elektrische Filter $H_f(s)$ unterdrückt.

Das System basiert im Weiteren auf der Idee, die beiden in Figur 9 dargestellten Bänder 102, 104 einzeln ins Basisband zu demodulieren, um dann die gesamte Rausch- bzw. Signalleistung in den beiden Bändern zu vergleichen. Dadurch lässt sich genau ermitteln, ob die aktuelle Filterfrequenz zu hoch oder zu niedrig ist.

Wegen dieser differentiellen Betrachtungsweise im Frequenzbereich erfolgt auch durch ein nicht vollständig unterdrücktes noch vorhandenes Drehratensignal keine Störung des Einstellvorgangs. Aufgrund der zwei Seitenbänder des amplitudenmodulierten Drehratensignals tritt je eine Komponente im Band 102 bzw. Band 104 auf. Da das Filter nach der obigen Gleichung (5) das Drehratensignal $F_c$ genauso wie das Quantisierungsrauschen $n_q$ unterdrückt, kann das Drehratensignal somit ebenfalls zur Regelung genutzt werden.

Figur 10 zeigt den grundlegenden Aufbau eines Drehratensensors 108 mit der erfindungsgemäßen automatischen Frequenzanpassung des Schleifenfilters 110 der sekundären Regelschleife gemäß einer vorteilhaften Ausführungsform.

Zur groben Angleichung der Frequenz $f_f$ des elektrischen Filters 110 [mit der Übertragungsfunktion $H_f(s)$] an die primäre Resonanzfrequenz $f_d$ wird ein Signal $V_{tg}$, das proportional zum Steuersignal des Oszillators in der Phasenregelschleife (PLL) der primären Regelschleife ist, erzeugt. Dieses Signal wird (beispielsweise durch Addition) mit dem Steuersignal $V_t$ der Frequenzanpassung verrechnet.

Um die aktuelle Frequenz des elektrischen Filters anhand der Rauschformung zu bestimmen wird das Signal $V_{filt}$ zunächst mit $H_v(s)$ vorverstärkt und Frequenzen, die deutlich oberhalb der primären Resonanzfrequenz $f_d$ liegen, werden unterdrückt. Im nächsten Schritt wird das Signal mittels zweier Multiplizierer und den Frequenzen $f_{a,b}=f_d\pm f_1$ demoduliert um die resultierenden Basisbandsignale weiter auszuwerten.

Die benötigten Frequenzen $f_{a,b}$ können mit Hilfe der primären Regelschleife sehr leicht exakt generiert werden und weisen eine negative ($f_a$) bzw. positive ($f_b$) Frequenzverschiebung zur primären Resonanzfrequenz $f_d$ auf. Durch die Multiplikation erscheinen somit Signale mit Frequenzen, die vorher um $f_1$ über bzw. unter $f_d$ lagen, anschließend bei 0 Hz. Dies ermöglicht es, andere Signalkomponenten sehr einfach mit danach folgenden Tiefpassfiltern zu entfernen. Die Frequenzen $f_{a,b}$ können entweder mittels sinusförmigen Spannungen oder, um die Komplexität zu verringern, mittels Rechteckspannungen an die Multiplizierer angelegt werden.

Im nachfolgenden Schritt wird entweder die Leistung bzw. Signalstärke beider Signale durch Quadrieren gemessen oder durch Absolutwertbildung angenähert und anschließend die Differenz gebildet. Die Differenzgröße dient einem Regler, welcher vorteilhafterweise einen I-Anteil aufweist, als Fehlergröße. Der Regler kann dabei entweder kontinuierlich betrieben werden oder in Verbindungen mit einer Vorzeichenauswertung und einer digitalen Logik periodisch rückgesetzt werden.

Der nach dem erstmaligen Einregeln erzielte Wert für die Stellgröße $V_t$ kann in vorteilhafter Weise gespeichert werden um bei einem nachfolgenden Start schneller die richtige Frequenz $f_f$ zu erreichen. Hierfür kann die Frequenzanpassungsschaltung 100 eine entsprechende Speichervorrichtung aufweisen.

Das erfindungsgemäße Prinzip zur initialen Angleichung nutzt den bereits in der primären Regelschleife vorhandenen Oszillator und benötigt somit im Gegensatz zu den bekannten Anordnungen nur einen minimalen zusätzlichen Schaltungsaufwand. Zudem muss die zu erreichende Genauigkeit durch die zusätzliche Schaltung zur Anpassung der Frequenzen nur im Bereich von etwa 10 % der primären Resonanzfrequenz liegen.

Das erfindungsgemäße Prinzip zur Anpassung der Frequenzen ermöglicht es im Gegensatz zu den bekannten Verfahren, auch stark nicht-lineare Filter (wie z.B. Gm-C Filter) während des Betriebs anzupassen. Hinzu kommt, dass im Gegensatz zu den bekannten Verfahren keine Abhängigkeit von der Sensor-Transferfunktion besteht.

Aufgrund der eingesetzten geschlossenen Regelschleife besteht bei der Frequenzanpassung gemäß der vorliegenden Erfindung keine Anforderung an die Schaltung, bestimmte Komponenten besonders gut an das eigentliche Filter anzugleichen. Des Weiteren wird durch die Einbeziehung eines großen Rauschsignalbandes eine deutlich schnellere und genauere Frequenzanpassung als bei einer Betrachtung diskreter Signalkomponenten im Spektrum des Ausgangs Y der sekundären Regelschleife erreicht. Da dazu keinerlei zusätzliche Signale in die sekundäre Regelschleife eingespeist werden müssen oder die sekundäre Regelschleife kurzzeitig getrennt werden muss, kann keine Beeinträchtigung der Funktionalität zur Signalauslese entstehen.

Der geschätzte Flächenbedarf der vorgeschlagenen Implementierung ist durch die sehr effizient in der analogen Domäne zu implementierenden einfachen Komponenten deutlich geringer als bei den Lösungen gemäß dem aktuellen Stand der Technik.

Zusammenfassend kann durch den geringen Flächenbedarf ein kostengünstigeres System mit reduziertem Energieverbrauch durch die einsetzbaren Gm-C Filter und höherer Genauigkeit als mit bekannten Anordnungen realisiert werden.

Der Anwendungsbereich der vorliegenden Erfindung beschränkt sich aber nicht nur auf Drehratensensoren. Die Erfindung findet zudem auch Anwendung im Betrieb anderer Sensoren, wie z.B. Beschleunigungssensoren. Des Weiteren kann insbesondere die Frequenzanpassung während des Betriebs auch bei Analog-Digital-Wandlern mit geschlossenen Regelschleifen (z.B. $\Delta\Sigma$M ADC) zum Einsatz kommen. Das Konzept ist zudem bei jeglicher Art von Filtern anwendbar, bei der eine breitbandige Anregung des Filters erfolgt und somit anhand eines der Signale in der Anwendung, die Transferfunktion des Filters näherungsweise abgebildet wird.

**Patentansprüche**

1. Verfahren zur Anpassung der Resonanzfrequenz eines Schleifenfilters in einem Delta-Sigma-Modulator an einen vorgegebenen Frequenzwert, wobei der Delta-Sigma-Modulator umfasst:

   einen Eingangsanschluss, der mit dem Schleifenfilter verbunden ist, einen Quantisierer, der mit einem Ausgang des Schleifenfilters verbunden ist, und einen Rückkopplungszweig, der einen Ausgang des Quantisierers an den Eingangsanschluss zurückkoppelt,
   wobei das Verfahren die folgenden Schritte aufweist:

   Zuführen eines Filtereingangssignals des Schleifenfilters in eine Frequenzanpassungsschaltung,
   Ermitteln eines Rauschspektrums des Filtereingangssignals in einem ersten Frequenzband und einem zweiten Frequenzband, wobei das erste Frequenzband und das zweite Frequenzband symmetrisch um den vorgegebenen Frequenzwert angeordnet sind,
   Vergleich der Rauschspektren und Erzeugen eines Anpassungssignals, das eine Frequenzanpassung bewirkt, wenn die Rauschspektren voneinander abweichen,
   Rückkoppeln des Anpassungssignals der Frequenzanpassungsschaltung an einen Steuereingang des Schleifenfilters zum Einstellen der Filterfrequenz in Antwort auf das Vergleichsergebnis.

2. Verfahren nach Anspruch 1, wobei zum Vergleichen der Rauschspektren das erste und das zweite Frequenzband jeweils einzeln in ein Basisband demoduliert werden und die gesamte Rauschleistung in den beiden Frequenzbändern verglichen wird.

3. Verfahren nach Anspruch 1 oder 2, weiterhin umfassend den Schritt einer anfänglichen Anpassung der Resonanzfrequenz des Schleifenfilters durch Eingabe des vorgegebenen Frequenzwertes als Startwert.

4. Delta-Sigma-Modulator mit einem Eingangsanschluss, der mit dem Schleifenfilter verbunden ist, einem Quantisierer, der mit einem Ausgang des Schleifenfilters verbunden ist, und einem Rückkopplungszweig, der einen Ausgang des Quantisierers an den Eingangsanschluss zurückkoppelt, wobei der Delta-Sigma-Modulator weiterhin umfasst:

   eine Frequenzanpassungsschaltung, deren Eingang mit einem Eingang des Schleifenfilters zum Empfangen eines Filtereingangssignals des Schleifenfilters verbunden ist, und deren Ausgang an einen Steuereingang des Schleifenfilters rückgekoppelt ist,
   wobei die Frequenzanpassungsschaltung einen ersten und einen zweiten Demodulatorzweig aufweist, die betrieben werden, um ein Rauschspektrum des Filtereingangssignals in einem ersten Frequenzband und einem zweiten Frequenzband zu ermitteln, wobei das erste Frequenzband und das zweite Frequenzband symmetrisch um die vorgegebene Frequenz angeordnet sind, und wobei die Frequenzanpassungsschaltung weiterhin eine Vergleichereinheit aufweist, die betrieben wird, um die Rauschspektren zu vergleichen und an dem Ausgang der Frequenzanpassungsschaltung ein Anpassungssignal zu erzeugen, das eine Frequenzanpassung bewirkt, wenn die Rauschspektren voneinander abweichen.

5. Delta-Sigma-Modulator nach Anspruch 4, wobei die Frequenzanpassungsschaltung weiterhin einen Vorverstärker zum Verstärken des Filtereingangssignals umfasst, der zwischen dem Eingang der Frequenzanpassungsschaltung und den Demodulatorzweigen angeordnet ist.

6. Delta-Sigma-Modulator nach Anspruch 4 oder 5, wobei der erste Demodulatorzweig einen ersten Multiplizierer aufweist, der betrieben wird, um das Filtereingangssignal mit einer ersten Vergleichsfrequenz zu multiplizieren, die niedriger ist als der vorgegebene Frequenzwert, wobei der zweite Demodulatorzweig einen zweiten Multiplizierer aufweist, der betrieben wird, um das Filtereingangssignal mit einer zweiten Vergleichsfrequenz zu multiplizieren, die höher ist als der vorgegebene Frequenzwert und wobei die erste und die zweite Vergleichsfrequenz symmetrisch um den vorgegebenen Frequenzwert angeordnet sind.

7. Delta-Sigma-Modulator nach einem der Ansprüche 4 bis 6, wobei jeder der Demodulatorzweige jeweils mindestens ein Filterelement aufweist.

8. Delta-Sigma-Modulator nach einem der Ansprüche 4 bis 7, wobei jeder der Demodulatorzweige jeweils einen Quadrierer aufweist und die Ausgänge der Quadrierer mit einem Addierer verbunden sind, um eine Differenz der an den Ausgängen der Quadrierer anliegenden Signale zu bestimmen und einen Differenzwert auszugeben.

9. Delta-Sigma-Modulator nach einem der Ansprüche 4 bis 7, wobei jeder der Demodulatorzweige jeweils ein Absolutwertelement zum Bestimmen eines Absolutwertes aufweist und die Ausgänge der Absolutwertelemente mit einem Addierer verbunden sind, um eine Differenz der an den Ausgängen der Absolutwertelemente anliegenden Signale zu bestimmen und einen Differenzwert auszugeben.

10. Delta-Sigma-Modulator nach einem der Ansprüche 8 oder 9, weiterhin umfassend eine Regeleinheit, die mit dem Differenzwert beaufschlagt wird und daraus das Anpassungssignal erzeugt.

11. Schaltungsanordnung zum Auslesen eines kapazitiven Drehratensensors mit mindestens einer primären Masse und mindestens einer sekundären Masse, die mit der primären Masse verbunden ist, wobei die primäre Masse im Betrieb zu einer Primärschwingung angeregt wird, und wobei die sekundäre Masse in einer Richtung quer zur Primärschwingung aus einer Ruhelage ausgelenkt wird, wenn der Drehratensensor um eine sensitive Achse, die quer zu der Richtung der Primärschwingung und zu der Richtung der Auslenkung der sekundären Masse verläuft, rotiert, wobei die Schaltungsanordnung aufweist:

einen Delta-Sigma-Modulator mit mindestens einer Regelschleife zum Durchführen einer Kraftrückkopplung, welche die sekundäre Masse durch Anlegen eines Rückstellsignals in ihre Ruhelage zurückstellt, wobei das Rückstellsignal ein Modulatorausgangssignal des Delta-Sigma-Modulators bildet, wobei der Delta-Sigma-Modulator durch einen Delta-Sigma-Modulator nach einem der Ansprüche 4 bis 10 gebildet ist und der vorgegebene Frequenzwert die Frequenz der Primärschwingung ist,
eine Steuereinheit zum Berechnen und Ausgeben eines Drehratensignals aus dem Modulatorausgangssignal.

12. Schaltungsanordnung nach Anspruch 11, wobei die Frequenz der Primärschwingung mittels einer geschlossenen phasenverriegelten Regelschleife geregelt wird, die einen Oszillator aufweist, und wobei die phasenverriegelte Regelschleife mit einem Steuereingang des Schleifenfilters zum Empfangen eines Steuersignals des Oszillators verbunden ist.

13. Schaltungsanordnung nach Anspruch 6 und 11 oder 6 und 12, wobei die phasenverriegelte Regelschleife weiterhin betrieben werden kann, die erste und die zweite Vergleichsfrequenz an die Frequenzanpassungsschaltung auszugeben.

14. Schaltungsanordnung nach einem der Ansprüche 11 bis 13, weiterhin umfassend eine Speichervorrichtung zum Abspeichern des Anpassungssignals.

15. Coriolisdrehratensensor mit mindestens einer primären Masse und mindestens einer sekundären Masse, die mit der primären Masse verbunden ist, wobei die primäre Masse im Betrieb zu einer Primärschwingung angeregt wird, und wobei die sekundäre Masse in einer Richtung quer zur Primärschwingung ausgelenkt wird, wenn der Coriolisdrehratensensor um eine sensitive Achse rotiert,
wobei der Coriolisdrehratensensor zum Auslesen eines Drehratensignals eine Schaltungsanordnung nach einem der Ansprüche 11 bis 14 aufweist.

**Claims**

1. Method for adjusting the resonance frequency of a loop filter in a delta-sigma modulator to a predetermined frequency value, wherein the delta-sigma modulator comprises:

an input terminal that is connected to the loop filter, a quantizer that is connected to an output of the loop filter, and a feedback branch that couples an output of the quantizer back to the input terminal, wherein the method comprises the following steps:

inputting a filter input signal of the loop filter into a frequency adjustment circuit,
determining a noise spectrum of the filter input signal in a first frequency band and a second frequency band, wherein the first frequency band and the second frequency band are arranged symmetrically around the predetermined frequency,
comparing the noise spectra and generating an adjustment signal that causes a frequency adjustment when the noise spectra deviate from one another,
feeding back the adjustment signal of the frequency adjustment circuit to a control input of the loop filter for setting the filter frequency in response to the comparative result.

2. Method according to Claim 1, wherein the first and the second frequency band are each demodulated into a base band for comparing the noise spectra and wherein the overall noise power in the two frequency bands is compared.

3. Method according to Claim 1 or 2, further comprising the step of an initial adjustment of the resonance frequency of the loop filter through entry of the predetermined frequency value as a starting value.

4. Delta-sigma modulator with an input terminal that is connected to the loop filter, a quantizer that is connected to an output of the loop filter, and a feedback branch that couples an output of the quantizer back to the input terminal, wherein the delta-sigma modulator further comprises:

a frequency adjustment circuit whose input is connected to an input of the loop filter for receiving a filter input signal of the loop filter and whose output is coupled back to a control input of the loop filter, wherein the frequency adjustment circuit has a first and a second demodulator branch that are operated to determine a noise spectrum of the filter input signal in a first frequency band and a second frequency band, wherein the first frequency band and the second frequency band are arranged symmetrically around the predetermined frequency, and wherein the frequency adjustment circuit further has a comparative unit that is operated to compare the noise spectra and to generate an adjustment signal, which causes a frequency adjustment when the noise spectra deviate from one another, at the output of the frequency adjustment circuit.

5. Delta-sigma modulator according to Claim 4, wherein the frequency adjustment circuit further comprises a pre-amplifier for amplifying the filter input signal that is arranged between the input of the frequency adjustment circuit and the demodulator branches.

6. Delta-sigma modulator according to Claim 4 or 5, wherein the first demodulator branch has a first multiplier that is operated to multiply the filter input signal with a first comparative frequency that is lower than the predetermined frequency value, wherein the second demodulator branch has a second multiplier that is operated to multiply the filter input signal with a second comparative frequency that is higher than the predetermined frequency value and wherein the first and the second comparative frequency are arranged symmetrically around a predetermined frequency value.

7. Delta-sigma modulator according to one of the Claims 4 to 6, wherein each of the demodulator branches has at least one filter element.

8. Delta-sigma modulator according to one of the Claims 4 to 7, wherein each of the demodulator branches has a squaring device that is connected to an adding device to determine a difference of the signals that are applied to the outputs of the squaring devices and to output a difference value.

9. Delta-sigma modulator according to one of the Claims 4 to 7, wherein each of the demodulator branches respectively has an absolute value element for determining an absolute value and the outputs of the absolute values are connected to an adding device to determine a difference of the signals that are applied to the outputs of the absolute value elements and to output a difference value.

10. Delta-sigma modulator according to one of the Claims 8 or 9, further comprising a control unit that is impinged with the difference value and that creates the adjustment signal based on said difference value.

11. Circuit arrangement for reading out of a capacitive angular rate sensor with at least one primary mass and at least one secondary mass that is connected to the primary mass, wherein the primary mass is excited to a primary oscillation during operation and wherein the secondary mass is deflected from a resting position in a direction that is transversal to the primary oscillation when the angular rate sensor rotates around a sensitive axis that is transversal to the direction of the primary oscillation and to the direction of the deflection of the secondary mass, wherein the circuit arrangement comprises:

a delta-sigma modulator with at least one control loop to perform a force feedback that resets the secondary mass into its resting position by means of applying a reset signal, wherein the reset signal forms a modulator output signal of the delta-sigma modulator, wherein the delta-sigma modulator is formed by a delta-sigma modulator according to one of the Claims 4 to 10 and wherein the predetermined frequency value is the frequency of the primary oscillation,
a control unit for calculating and outputting an angular rate signal out of the modulator output signal.

12. Circuit arrangement according to Claim 11, wherein the frequency of the primary oscillation is controlled by means of a closed phase-locked control loop that has an oscillator, and wherein the phase-locked control loop is connected to a control input of the loop filter for receiving a control signal of the oscillator.

13. Circuit arrangement according to Claim 11 or 12, as far as dependent on Claim 6, wherein the phase-locked control loop can be operated further to output the first and the second comparative frequency to the frequency adjustment circuit.

14. Circuit arrangement according to one of the Claims 11 to 13, further comprising a memory device for saving the adjustment signal.

15. Coriolis angular rate sensor with at least one primary mass and at least one secondary mass that is connected to the primary mass, wherein the primary mass is excited to perform a primary oscillation during operation and wherein the secondary mass is deflected in a direction that is transversal to the primary oscillation when the Coriolis angular rate sensor rotates around a sensitive axis,
wherein the Coriolis angular rate sensor has a circuit arrangement according to one of the Claims 11 to 14 for reading out an angular rate signal.


**Revendications**

1. Procédé pour adapter la fréquence de résonance d'un filtre à boucle dans un modulateur delta-sigma, à une valeur de fréquence prédéterminée, le modulateur delta-sigma comprenant :

un raccord d'entrée, qui est relié au filtre à boucle, un quantificateur, qui est relié à une sortie du filtre à boucle, et une branche de rétroaction, qui assure le rétrocouplage d'une sortie du quantificateur au raccord d'entrée, le procédé comprenant les étapes suivantes :

l'amenée d'un signal d'entrée de filtre du filtre à boucle dans un circuit d'adaptation de fréquence, la détermination d'un spectre de bruit du signal d'entrée de filtre dans une première bande de fréquence et dans une deuxième bande de fréquence, la première bande de fréquence et la deuxième bande de fréquence étant agencées de manière symétrique autour de ladite valeur de fréquence prédéterminée, la comparaison des spectres de bruit et la production d'un signal d'adaptation, qui produit une adaptation de fréquence, lorsque les spectres de bruit présentent un écart entre eux, le rétrocouplage du signal d'adaptation du circuit d'adaptation de fréquence à une entrée de commande du filtre à boucle pour régler la fréquence de filtre en réponse au résultat de comparaison.

2. Procédé selon la revendication 1, d'après lequel pour la comparaison des spectres de bruit, la première et la deuxième bande de fréquence sont démodulées respectivement de manière individuelle en une bande de base, et l'on compare la puissance totale de bruit dans les deux bandes de fréquence.

3. Procédé selon la revendication 1 ou la revendication 2, comprenant, en outre, l'étape d'une adaptation de départ de la fréquence de résonnance du filtre à boucle, par saisie de ladite valeur de fréquence prédéterminée comme valeur de démarrage.

**4.** Modulateur delta-sigma comprenant un raccord d'entrée, qui est relié au filtre à boucle, un quantificateur, qui est relié à une sortie du filtre à boucle, et une branche de rétroaction, qui assure le rétrocouplage d'une sortie du quantificateur au raccord d'entrée, le modulateur delta-sigma comprenant en outre :

un circuit d'adaptation de fréquence, dont l'entrée est reliée à une entrée du filtre à boucle pour la réception d'un signal d'entrée de filtre du filtre à boucle, et dont la sortie est rétro-couplée à une entrée de commande du filtre à boucle,
modulateur dans lequel
le circuit d'adaptation de fréquence présente une première et une deuxième branche de démodulateur, que l'on fait fonctionner de manière à déterminer un spectre de bruit du signal d'entrée de filtre dans une première bande de fréquence et dans une deuxième bande de fréquence, la première bande de fréquence et la deuxième bande de fréquence étant agencées de manière symétrique autour de ladite valeur de fréquence prédéterminée, et le circuit d'adaptation de fréquence comprend, par ailleurs, une unité de comparaison, que l'on fait fonctionner de manière à comparer les spectres de bruit et produire à la sortie du circuit d'adaptation de fréquence, un signal d'adaptation de fréquence, qui produit une adaptation de fréquence lorsque les spectres de bruit présentent un écart entre eux.

**5.** Modulateur delta-sigma selon la revendication 4, dans lequel le circuit d'adaptation de fréquence comprend, par ailleurs, un préamplificateur pour amplifier le signal d'entrée de filtre, qui est agencé entre l'entrée du circuit d'adaptation de fréquence et les branches de démodulateur.

**6.** Modulateur delta-sigma selon la revendication 4 ou la revendication 5, dans lequel la première branche de démodulateur présente un premier multiplicateur, que l'on fait fonctionner de manière à multiplier le signal d'entrée de filtre par une première fréquence de comparaison, qui est inférieure à ladite valeur de fréquence prédéterminée, dans lequel la deuxième branche de démodulateur présente un deuxième multiplicateur, que l'on fait fonctionner de manière multiplier le signal d'entrée de filtre par une deuxième fréquence de comparaison, qui est supérieure à ladite valeur de fréquence prédéterminée, et dans lequel la première et la deuxième fréquence de comparaison sont agencées de manière symétrique par rapport à ladite valeur de fréquence prédéterminée.

**7.** Modulateur delta-sigma selon l'une des revendications 4 à 6, dans lequel chacune des branches de démodulateur comprend respectivement au moins un élément de filtre.

**8.** Modulateur delta-sigma selon l'une des revendications 4 à 7, dans lequel chacune des branches de démodulateur présente respectivement un module d'élévation au carré, et les sorties des modules d'élévation au carré sont reliées à un additionneur, pour déterminer une différence des signaux présents aux sorties des modules d'élévation au carré, et délivrer une valeur de différence.

**9.** Modulateur delta-sigma selon l'une des revendications 4 à 7, dans lequel chacune des branches de démodulateur présente respectivement un élément de valeur absolue pour déterminer une valeur absolue, et les sorties des éléments de valeur absolue sont reliées à un additionneur pour déterminer une différence des signaux présents aux sorties des éléments de valeur absolue, et délivrer une valeur de différence.

**10.** Modulateur delta-sigma selon l'une des revendications 8 ou 9, comprenant, en outre, une unité de régulation, qui est alimentée par ladite valeur de différence pour en produire ledit signal d'adaptation.

**11.** Agencement de circuit pour assurer la lecture d'un capteur de vitesse angulaire, capacitif, comprenant au moins une masse primaire et au moins une masse secondaire, qui est reliée à la masse primaire, agencement de circuit dans lequel la masse primaire est, en fonctionnement, soumise à une excitation selon une oscillation primaire, et dans lequel la masse secondaire est déviée d'une position de repos, dans une direction transversalement à l'oscillation primaire, lorsque le capteur de vitesse angulaire est en rotation autour d'un axe sensitif, qui s'étend transversalement à la direction de l'oscillation primaire et à la direction de la déviation de la masse secondaire, l'agencement de circuit comprenant :

un modulateur delta-sigma avec au moins une boucle de régulation pour l'exécution d'une rétroaction de force pour assurer le rappel de la masse secondaire dans sa position de repos, par l'application d'un signal de rappel, le signal de rappel formant un signal de sortie de modulateur du modulateur delta-sigma, le modulateur delta-sigma étant formé par un modulateur delta-sigma selon l'une des revendications 4 à 10, et ladite valeur de fréquence prédéterminée étant la fréquence de l'oscillation primaire,

et une unité de commande pour calculer et délivrer un signal de vitesse angulaire à partir du signal de sortie de modulateur.

12. Agencement de circuit selon la revendication 11, dans lequel la fréquence de l'oscillation primaire est régulée à l'aide d'une boucle de régulation fermée, verrouillée en phase, qui présente un oscillateur, et dans lequel la boucle de régulation fermée, verrouillée en phase, est reliée à une entrée de commande du filtre à boucle pour la réception d'un signal de commande de l'oscillateur.

13. Agencement de circuit selon les revendications 6 et 11 ou les revendications 6 et 12, dans lequel il est en outre possible de faire fonctionner la boucle de régulation, verrouillée en phase, pour délivrer la première et la deuxième fréquence de comparaison au circuit d'adaptation de fréquence.

14. Agencement de circuit selon l'une des revendications 11 à 13, comprenant, en outre, un dispositif de mémoire pour mémoriser le signal d'adaptation.

15. Capteur de vitesse angulaire de Coriolis comprenant au moins une masse primaire et au moins une masse secondaire, qui est reliée à la masse primaire, capteur dans lequel la masse primaire est, en fonctionnement, soumise à une excitation selon une oscillation primaire, et dans lequel la masse secondaire est déviée dans une direction transversalement à l'oscillation primaire, lorsque le capteur de vitesse angulaire de Coriolis est en rotation autour d'un axe sensitif,
le capteur de vitesse angulaire de Coriolis comprenant un agencement de circuit selon l'une des revendications 11 à 14, pour assurer la lecture d'un signal de vitesse angulaire.

**Primäre Regelschleife**

$H_p(s)$

Elektronik

$H_s(s)$

Elektronik

**Sekundäre Regelschleife**

*Fig. 1*

**Sekundäre Regelschleife**

Sekundäre Masse · Elektrisches Filter

$F_C$ · $H_s(s)$ · C/V · $V_{filt}$ · $H_f(s)$ · $k_q$ · $n_q$ · Y

F(s)

*Fig. 2*

EP 3 222 968 B1

Fig. 3

Fig. 4

*Fig. 5*

Fig. 6a

Fig. 6b

Fig. 7a

Fig. 7b

*Fig. 8a*

*Fig. 8b*

Fig. 9a

Fig. 9b

**Primäre Regelschleife**

Primäre Masse — $H_p(s)$ — C/V — PLL — $f_d+f_1$ / $f_d-f_1$ — $V_{tg}$

$V_t$

**Sekundäre Regelschleife**

Sekundäre Masse — $F_C$ — $H_s(s)$ — C/V — $V_{filt}$ — $H_f(s)$ — $k_q$ — $n_q$ — Y — F(s)

110

**Frequenzanpassung**

$f_b=f_d+f_1$ — $V_b$ — $|u|$ / $u^2$

$H_v(s)$ — AAF — $V_a$ — $|u|$ / $u^2$ — Integrator — $V_t$

$f_a=f_d-f_1$

108

100

***Fig. 10***

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7042375 B2
- US 7324028 B2
- DE 19910415 A1

**In der Beschreibung aufgeführte Nicht-Patentliteratur**

- **T. NORTHEMANN ; M. MAURER ; S. ROMBACH ; A. BUHMANN ; Y. MANOLI.** Drive and sense interface for gyroscopes based on bandpass sigma-delta modulators. *Proc. IEEE Int. Circuits and Systems (ISCAS) Symp,* 2010, 3264-3267
- **TSIVIDIS, Y.** Integrated continuous-time filter design - an overview. *Solid-State Circuits, IEEE Journal of,* Marz 1994, vol. 29 (3), 166, , 176
- **AFIFI, M. ; MAURER, M. ; HEHN, T. ; TASCHWER, A. ; MANOLI, Y.** An automatic tuning technique for background frequency calibration in gyroscope interfaces based on high order bandpass Delta-Sigma modulators. *Circuits and Systems (ISCAS), 2015 IEEE International Symposium on,* 24. Mai 2015, 1730, , 1733
- **TSIVIDIS, Y.** Self-tuned filters. *Electronics Letters,* 11. Juni 1981, vol. 17 (12), 406, , 407
- **HUANZHANG HUANG ; LEE, E.K.F.** Frequency and Q tuning techniques for continuous-time bandpass sigma-delta modulator. *Circuits and Systems, 2002. ISCAS 2002. IEEE International Symposium on,* 2002, vol. 5, V-589, , V-592

- **LEE, E.K.F.** Frequency and Q tuning techniques for continuous-time bandpass sigma-delta modulator. *Circuits and Systems, 2002. ISCAS 2002. IEEE International Symposium on,* 2002, vol. 5, V-589, , V-592
- **YUN-SHIANG SHU ; BANG-SUP SONG ; BACRANIA, K.** A 65nm CMOS CT $\Delta\Sigma$ Modulator with 81dB DR and 8MHz BW Auto-Tuned by Pulse Injection. *Solid-State Circuits Conference, 2008. ISSCC 2008. Digest of Technical Papers. IEEE International,* 03. Februar 2008, 500, , 631
- **EZEKWE, C.D. ; BOSER, B.E.** A Mode-Matching $\Delta\Sigma$ Closed-Loop Vibratory-Gyroscope Readout Interface with a 0.004°/s/$\sqrt{Hz}$ Noise Floor over a 50Hz Band. *Solid-State Circuits Conference, 2008. ISSCC 2008. Digest of Technical Papers. IEEE International,* 03. Februar 2008, 580-637
- **EZEKWE, C.D. ; BOSER, B.E.** A Mode-Matching $\Delta\Sigma$ Closed-Loop Vibratory-Gyroscope Readout Interface with a 0.004°/s/VHz Noise Floor over a 50Hz Band. *Solid-State Circuits Conference, 2008. ISSCC 2008. Digest of Technical Papers. IEEE International,* 03. Februar 2008, 580-637